(19) **Europäisches Patentamt European Patent Office Office européen des brevets**

(11) **EP 2 932 808 B1**

(12) **EUROPEAN PATENT SPECIFICATION**

(45) Date of publication and mention of the grant of the patent:
**11.03.2026 Bulletin 2026/11**

(21) Application number: **13811160.4**

(22) Date of filing: **13.12.2013**

(51) International Patent Classification (IPC):
$H05K\ 3/32^{(2026.01)}$   $C09J\ 9/02^{(2006.01)}$
$C23C\ 18/44^{(2006.01)}$   $H01B\ 1/22^{(2006.01)}$
$H01R\ 4/04^{(2006.01)}$   $C09J\ 7/40^{(2018.01)}$
$C09J\ 11/00^{(2006.01)}$   $C08K\ 7/16^{(2006.01)}$
$C08K\ 9/12^{(2006.01)}$   $C23C\ 18/16^{(2006.01)}$
$C23C\ 18/28^{(2006.01)}$   $C23C\ 18/30^{(2006.01)}$

(52) Cooperative Patent Classification (CPC):
**C09J 9/02; C09J 7/401; C09J 11/00; H01B 1/22; H05K 3/321; H05K 3/323;** C08K 7/16; C08K 9/12; C23C 18/1635; C23C 18/285; C23C 18/30; C23C 18/44; H05K 2201/0221; H05K 2203/013

(86) International application number:
**PCT/EP2013/076535**

(87) International publication number:
**WO 2014/090989 (19.06.2014 Gazette 2014/25)**

(54) **METHOD OF APPLYING A CONDUCTIVE ADHESIVE AND APPARATUS FOR CARRYING OUT THE METHOD**

VERFAHREN ZUM AUFTRAGEN EINES LEITENDEN HAFTSTOFFS UND VORRICHTUNG ZUR DURCHFÜHRUNG DES VERFAHRENS

PROCÉDÉ D'APPLICATION D'UN ADHÉSIF CONDUCTEUR ET APPAREIL POUR LA MISE EN OEUVRE DU PROCÉDÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.12.2012 GB 201222620**

(43) Date of publication of application:
**21.10.2015 Bulletin 2015/43**

(73) Proprietor: **Conpart AS**
**2013 Skjetten (NO)**

(72) Inventors:
• **KRISTIANSEN, Helge**
**N-0493 Oslo (NO)**
• **REDFORD, Keith**
**N-1481 Hagan (NO)**
• **HELLAND, Tore**
**N-0464 Oslo (NO)**
• **GAKKESTAD, Jakob**
**N-2016 Frogner (NO)**
• **OPLAND, Ottar**
**N-1283 Oslo (NO)**

(74) Representative: **Dehns**
**10 Old Bailey**
**London EC4M 7NG (GB)**

(56) References cited:
WO-A1-2012/023566   JP-A- 2000 137 233
US-A1- 2005 276 918   US-A1- 2007 138 649
US-A1- 2010 252 616   US-A1- 2011 017 841
US-A1- 2013 140 501   US-B1- 6 315 856
US-B1- 6 942 824

## Description

The invention relates to a method of applying a conductive adhesive to a substrate, for example to form a conductive connection in an electrical circuit.

Conductive adhesives (CAs) have been commercially available as an alternative to solder interconnects in electronic packaging for many years. Such adhesives are available as anisotropic conductive adhesives (ACAs) or isotropic conductive adhesives (ICAs), the two types being distinguished by their conductive properties. A CA typically consists of a non-conductive adhesive matrix filled with conductive particles. The mechanical strength of the CA comes from the adhesive matrix, while the conductive fillers provide electrical conductivity.

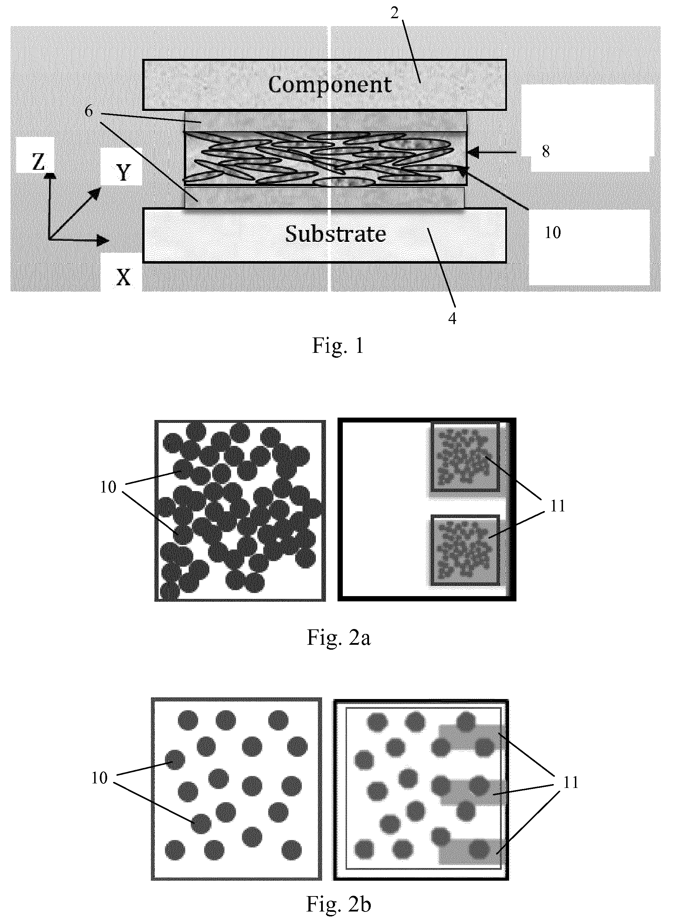

The most common CAs in the electronics industry consist of epoxy filled with silver powders or more preferably silver flakes. Figure 1 is a schematic drawing showing a CA of this type used to connect a component 2 to a substrate 4. In this example the adhesive uses silver flakes present in large amounts to provide isotropic conductivity. Both of the component 2 and substrate 4 have an electrical contact 6. The CA, which comprises a polymer resin matrix 8 and silver flakes 10, is used to electrically connect the two contacts 6. The silver flakes 10 form a conductive network that allows for conduction of electricity in all directions. Before the adhesive is cured, the silver flakes (in the adhesives) have a tendency to be oriented both during application and under the influence of gravity. This results in a better conductivity in the plane of the substrate compared to conductivity normal to this plane and hence the conductive properties of the adhesive are not truly isotropic. Traditionally, CA compounds have been heavily loaded with silver particles, typically in the range of 25 - 30 volume% (up to 80 wt%), to ensure sufficient electrical conductivity also in the z-direction (for an ICA). This leads to a high metal content for the adhesive. Such a high metal particle loading causes significant changes in the mechanical properties of the adhesives, including increased bulk modulus, reduced flexibility (a more brittle response) and an excessive use of precious metal (and hence excessive costs).

With an ICA the conductive particles 10 inside an adhesive boundary are allowed to be in contact with each other, but are not required to be in contact with each other. This is shown in Figure 2a. The box in the left hand drawing of Figure 2a shows the adhesive boundary, while the circles are conductive particles 10, which might for example be silver flakes 10 as in Figure 1. An ICA can effectively be used as long as the adhesive boundary is restricted to cover only one contact area on the component side, and one contact area on the substrate side. The conductive particles are allowed to come into contact, but are not required to be in contact with each other, inside the boundaries of area to which the adhesive is applied. In the right hand drawing of Figure 2a the two shaded areas 11 show two contact pads, and each of the adhesive boundaries only covers one contact pad.

An ACA should be used if the adhesive boundary will cover two or more electrical contact areas on the component side and substrate side. The conductive particles 10 inside the adhesive boundary are not allowed to be in contact with each other, since this would create possibilities of short circuit between the adjacent contact pads. This is shown in Figure 2b. The shaded areas 11 in the right hand drawing of Figure 2b show three contact pads, which are all within the adhesive boundary. However, since the conductive particles 10 are separated then there is no short circuit between adjacent contact pads.

In general the relative amount of the particles (e.g. volume fraction) determines whether the conductivity is isotropic or anisotropic. It can readily be seen in Figure 2a and Figure 2b that a significantly reduced proportion of conductive particles is used in an ACA compared to an ICA.

An alternative to silver flake based CA is disclosed in US 6942824, comprising a resin component, a photoinitiator, and metal-coated polymer beads. The resin is UV cured. The metal coating of the beads provides electrical conductivity. The polymer beads are between 15 and 30 $\mu$m in diameter and are coated with gold or silver having a thickness of between 20 and 100 nm.

In addition to those discussed above, the conductive particles used for CAs also include solid metal powders, such as silver powder. Metal powders use a relatively large amount of metal, which leads to disadvantages in terms of cost and also in the mechanical properties of the adhesive. In the electronics industry there is an ongoing trend of miniaturisation. Reductions in the size of electrical components and electrical circuits results in a corresponding need for miniaturisation of the conductive connections between components. There is also an increasing demand for 'throw-away' electronics and flexible circuits. Both of these can require circuitry mounted on paper products (for example for musical greetings cards) or on thin flexible plastic films. Solder interconnects need the solder to be applied at a high temperature in a molten state and hence are not suited to such applications since the paper of thin film substrate is sensitive to temperature and could be damaged. CAs find wide application as an alternative to solder interconnects for miniaturised and flexible circuits but there are challenges in applying CAs in small, accurately located, amounts. Current techniques for the application of CAs in small amounts involve the use of screen printing or similar. This is limited in resolution and requires new screens to be produced for each product. US 6315856 B1 discloses a screen printing technique for the deposition of ACAs. US 6315856 B1 also discloses ink jet based deposition methods for the deposition of ICAs.

An alternative to the use of, e.g., screen printing techniques for CAs is the use of droplet jetting technology, for example as described in US 7767266. This document relates primarily to solder pastes but also more generally discloses a method used for jetting droplets of viscous medium onto a substrate. Droplets of the viscous medium are propelled through a nozzle on to the substrate by the use of a piston. The viscous medium is disclosed as including; solder paste, flux, adhesive, conductive adhesive or any other kind of medium used for fastening components on a substrate. There is however no specific indication of a type of conductive adhesive that should be used.

With this type of technology it is necessary for the size of the droplets to decrease as the size of the components decreases. Currently only solder powder of Type 5 (particle size equal or smaller than 25 $\mu$m, see IPC J-STD-005) is suitable for this technology, due to problems with clogging of nozzle opening. There is a strong relationship between particle size and nozzle opening, and the droplet size.

Solder powders seemingly function in the droplet jetting technology, however there are some critical limitations with solders. The high soldering temperatures required for lead-free (>200 °C) & lead-containing solders (>180 °C) are not suitable for all substrates and components, and solders do not work well with glassy substrates and components. Another concern is that solder powders normally have a large size distribution (Type 5 indicates diameters between 15 $\mu$m to 25 $\mu$m), meaning that the nozzle opening has to be designed with respect to the largest particles.

Whilst the use of CAs with droplet technology has been suggested in relation to noble metal powder based CAs, such as silver powder CAs, these have the same concerns as solder powders with respect to the size distribution of particles in the silver powder. In addition the cost of utilizing a solid powder of noble metals is often a problem. Another effect of using solid metal powders (not only noble) is sedimentation and clogging, mainly due to large density differences between solid metal powder and adhesive component. Metal flake based conductive adhesives also introduce issues with droplet size, since the orientation strongly affects the effective cross-section of flakes. There is furthermore a significant problem with clogging of nozzles with the use of metal flakes, since they can turn sideways in the flow through a nozzle and gather together to block nozzles even when the nozzle is already oversized to take account of the relatively large maximum dimension of metal flakes compared to metal powders.

Viewed from a first aspect, the invention provides a method of applying a conductive adhesive comprising: using a conductive adhesive made up of conductive beads in an adhesive matrix, the conductive beads being metal coated polymer beads comprising a polymer core with a conductive metal coating and having a maximum dimension of 100 $\mu$m or less; and depositing one or more droplet(s) of the adhesive on a substrate via a nozzle; wherein the maximum dimension of the largest conductive bead in the conductive adhesive is half the nozzle width or less; wherein the maximum dimension of the largest conductive bead is less than three times the average maximum dimension of the conductive beads; and wherein the nozzle has an opening with a width of at least three times the average maximum dimension of the conductive beads.

Viewed from a second aspect, the invention provides an apparatus for applying adhesive comprising: a nozzle; and a reservoir of a conductive adhesive made up of conductive beads in an adhesive matrix, wherein the conductive beads are metal coated polymer beads that comprise a polymer core with a conductive metal coating and have a diameter of 100 $\mu$m or less and wherein the apparatus is arranged to dispense adhesive from the reservoir by depositing one or more droplet(s) of the adhesive on a substrate via the nozzle; wherein the maximum dimension of the largest conductive bead in the conductive adhesive is half the nozzle width or less; wherein the maximum dimension of the largest conductive bead is less than three times the average maximum dimension of the conductive beads; and wherein the nozzle has an opening with a width of at least three times the average maximum dimension of the conductive beads.

For conventional non-conductive adhesives it has long been known that a larger throughput and greater accuracy at small scales can be achieved by dispensing the adhesive using droplets applied by nozzles. It is also known to deposit molten solder using similar techniques. However, as noted above this technique was considered by those skilled in the art to be ineffective for CAs since the presence of conductive particles has been found to cause blockages. The inventors have made the non-obvious realisation that whilst this may hold for CAs comprising metal flakes, it does not in fact apply for CAs comprising conductive beads of the type having a polymer core and metal coating, preferably well defined conductive beads as discussed below. Polymer beads have similar mechanical characteristics to the epoxy matrix and this can hence result in improved coefficient of thermal expansion between the resin and the conductive elements.

The proposed combination of the use of a conductive adhesive comprising metal coated polymer beads along with a droplet deposition technique also provides considerable advantages compared to the known use of solder powders with similar droplet deposition technology, since as well as the ability to use low temperatures the conductive beads can also have a smoother surface and better size distribution than solder powders (or indeed noble metal powders in alternative conductive adhesives), meaning that friction and wear at the nozzle is reduced and the nozzle can be made significantly smaller for a given average particle size. This gives rise to further advantages in terms of more accurate control of the size of the deposited droplets, the ability to deposit conductive adhesives with a greater volume fraction of conductive particles (for a given nozzle size) and the ability to deposit smaller droplets (for a given particle size).

Thus, surprisingly and contrary to commonly held views in the art, the inventors have found that it is possible to highly effectively apply conductive adhesives by depositing droplets through a nozzle when the conductive particles within the adhesive are conductive beads. Whilst metal coated polymer beads in conductive adhesives have been proposed in the past they have generally been treated as analogous to metal flake type adhesives and it was always considered therefore that they could not be applied in this way. The inventors have made the non-obvious realisation that such an application technique is possible. This has been found to be a result of the different flow characteristics of an adhesive composition with conductive beads compared to the flow of an adhesive composition with metal flakes, and as a result of the improved size distribution of conductive beads comprising metal coated polymer cores compared to the size distribution for silver powder conductive adhesives and solder powder products. The polymer core also allows for deformation of the conductive beads when under pressure and as a consequence the risk of blockages is further reduced compared to metal powders since it is possible for the polymer cores to deform and squeeze under pressure in the nozzle to clear any incipient blockages.

The inventors have found that the known phenomenon of blockages with CAs when used with nozzles arises since the tests used thin metal flakes with a ratio of shortest to longest axis of 25 to 1 or more. Non-laminar flow in the nozzle causes the adhesive flakes to become misaligned with the flow direction resulting in increased viscosity and clogging manifesting itself as pulsing of the adhesive or complete blockage. There are hence serious problems with the use of nozzles to dispense small amounts of CAs comprising metal flakes. These problems are solved by the use of an adhesive comprising metal coated polymer beads. Since beads of this type typically have a considerably smaller ratio of the shortest to longest axis and are manufactured by techniques that give well controlled size distribution then clogging cannot occur via this mechanism.

The use of an adhesive comprising metal coated polymer beads and deposited in one or more droplet(s) via a nozzle is hence a non-obvious step based on a conclusion that is not suggested in the prior art.

The method and apparatus of the invention can advantageously dispense droplets of the conductive adhesive in amounts less than 5 nl and as small as 1 nl or less, depending on the size of the conductive beads. Such amounts are not possible with the prior art dispensing techniques for conductive adhesives of comparable performance, including metal flake adhesives. As noted above the prior art silver powder conductive adhesives or solder powder products suffer other disadvantages compared to the proposed conductive adhesive with metal coated polymer beads.

The nozzle has an opening with a width of at least three times the maximum dimension of the conductive beads. This has been found to ensure that the adhesive flows smoothly through the nozzle. Notably, the width of the opening relative to the maximum dimension of the conductive particles can be considerably smaller for metal coated polymer beads than for metal powders due to the possibility of better control of size distribution for metal coated polymer beads. The maximum dimension of the conductive beads is the largest dimension for a bead of nominal size, for example this might be an average diameter of the beads when they are spherical beads. In preferred embodiments there are also constraints on the size distribution of the beads, as discussed below, which aids in ensuring well characterised flow of the conductive adhesive through the nozzle due to an absence of outsize particles.

The width of the nozzle as referenced herein is the width of the cross-section normal to the flow direction of the adhesive. Width is used herein in its geometrical sense and should not be confused with the maximum dimension of the nozzle. For a convex shape in the plane, the width is defined to be the smallest distance that can be formed between two opposite parallel lines tangent to its boundary, and the diameter is defined to be the largest such distance. Typically the nozzle would be circular and hence has a width that is the same as the length of the diameter of the circle. Other nozzle shapes may however be used, for example an ellipse, in which case the width would be the length of the minor axis. Thus, by way of an example only, for beads with a maximum dimension of 10 $\mu$m the diameter of the opening of the nozzle should be at least 30 $\mu$m, whereas for beads with a maximum dimension of 20 $\mu$m the diameter of the opening of the nozzle should be at least 60 $\mu$m.

There may also be a maximum dimension for the nozzle width and/or for the largest dimension of the nozzle. This can be set based on a required maximum size for the droplet deposited from the nozzle in order to allow for fine control of the amount of adhesive that this deposited. For example the maximum width and/or largest dimension may be 300 $\mu$m, more preferably 150 $\mu$m (when the size of the conductive beads permits). This sets a range of preferred diameters for the width of the nozzle for a given size of conductive beads, which is from three times the maximum dimension of the beads up to a maximum of 300 $\mu$m, or perhaps 150 $\mu$m. In preferred embodiments for smaller beads, for example conductive beads of a maximum dimension of 30 $\mu$m or less, the nozzle may have an opening with a width of from three times the maximum dimension of the beads up to a maximum of 300 $\mu$m, or smaller in preferred embodiments, for example 150 $\mu$m or 100 $\mu$m. For yet smaller beads of maximum dimension of 15 $\mu$m or less the width of the nozzle may be a maximum of 150 $\mu$m, or smaller in preferred embodiments, for example 100 $\mu$m or 60 $\mu$m. For still smaller beads the width of the nozzle of preferred embodiments is 40 $\mu$m or less. As will be seen from the table below a droplet deposited from a nozzle can contain significant numbers of conductive particles even when it has a very small volume. Advantages can therefore be gained from very small nozzles since even when only small amounts are deposited the adhesive will provide the necessary conductivity to complete an electrical connection.

By way of example the table below indicates how many particles are present in a droplet of conductive adhesive of given diameter. Note that the droplet is assumed to be spherical, and that for this example there is 50 volume % particles in the adhesive. Since the droplet may expand as it exits the nozzle then the droplet diameter may be slightly bigger than the nozzle diameter. It is however worth noting that a volume of adhesive passing through a nozzle with a diameter equivalent to the stated droplet diameter can be approximated as a cylinder of the same diameter as the nozzle and such a cylinder will have the same volume as a sphere of equivalent diameter when the height of the cylinder is two thirds of the diameter. Consequently, the figures below will also roughly indicate the number of particles in a controlled volume passed through a nozzle with an opening of the given diameter.

| Spherical droplet | | Particle diameter ($\mu$m) | | | |
|---|---|---|---|---|---|
| Diameter ($\mu$m) | Volume (nl) | 5 | 10 | 20 | 40 |
| 15 | 0,002 | 13 | 1 | 0 | 0 |
| 30 | 0,014 | 108 | 13 | 1 | 0 |
| 60 | 0,113 | 864 | 108 | 13 | 1 |
| 120 | 0,905 | 6912 | 864 | 108 | 13 |
| 240 | 7,24 | 55296 | 6912 | 864 | 108 |
| 480 | 57,91 | 442368 | 55296 | 6912 | 864 |
| | | Estimated number of particles per droplet | | | |

The nozzle may comprise a circular aperture extending through a cylinder or a truncated cone (frustocone) with the opening at an end of the cylinder or at the small diameter end of the truncated cone. The nozzle may comprise a tapered cavity leading to the opening and narrowing toward the opening. The cavity may be tapered in a linear fashion and hence form the shape of a cone. Alternatively the cavity may be tapered in a non-linear fashion for example to form a truncated ogive shape.

In a preferred embodiment the conductive adhesive is propelled through the nozzle by a piston. Thus, there may be a chamber connected to the nozzle and arranged to be filled with the adhesive, with a piston acting to pressurise the chamber and hence propel a droplet of adhesive out of the nozzle.

The method of the first aspect may include the use of a nozzle or apparatus with features as set out above.

The method or apparatus of the invention can advantageously be used in the application of conductive adhesives to any substrate, for example on conventional circuit boards, on flexible or paper circuits and so on. Significant advantages arise in temperature sensitive applications and applications requiring accurate control of the area to which adhesive is applied.

One preferred embodiment involves the use of the method or apparatus in the production of anisotropic or isotropic conductive films. An anisotropic or isotropic conductive film is conventionally produced by the application of a film-forming polymer composition containing conductive particles using a knife or roll. Thin strips are then formed by splitting the resultant film and carrier longitudinally.

The inventors have found that a conductive film may advantageously be produced using the application of multiple droplets via a nozzle onto a release layer. The adhesive is in effect printed onto the release layer. Due to the accuracy of the deposition of the adhesive and the direct transfer of the adhesive from the nozzle to the film there is less wastage and furthermore the adhesive can be applied selectively. It is not necessary to apply the adhesive over the whole width or length of the release layer.

Thus, in a preferred embodiment the substrate may be a release layer and the method or apparatus may be for producing a conductive film. The release layer may be any suitable material, such as a known release paper or film layer. A wide strip or area of conductive adhesive may be deposited and optionally subsequently divided into narrow strips by cutting the release layer. Alternatively a narrow strip or a pattern of a desired geometry may be applied to the release layer, which may be a narrow strip or other shape to match the desired geometry for the adhesive film. Advantageously, when the conductive film is formed by deposition in droplets from a nozzle it becomes possible to apply different types of conductive or insulating adhesives to different areas of a release layer. Conductive films may be produced from layers of different material for example a sandwich construction with insulating layers top and bottom with the particle containing material in the middle. Bespoke conductive films can therefore be created according to user requirements.

The invention, in a further aspect, provides a conductive film formed by deposition of a conductive adhesive onto a release layer, wherein the conductive adhesive is made up of conductive beads in an adhesive matrix, the conductive beads being metal coated polymer beads comprising a polymer core with a conductive metal coating and having a maximum dimension of 100 $\mu$m or less; and wherein the film is formed by depositing one or more droplet(s) of the adhesive on to the release layer via a nozzle; wherein the maximum dimension of the largest conductive bead in the conductive adhesive is half the nozzle width or less; wherein the maximum dimension of the largest conductive bead is less than three times the average maximum dimension of the conductive beads; and wherein the nozzle has an opening with a width of at least three times the average maximum dimension of the conductive beads. The conductive film of this aspect may comprise a film formed by deposition of a conductive adhesive in accordance with any or the preferred features discussed above in relation to the method of the first aspect or the apparatus of the second aspect

The further optional features discussed below relate equally to the method of the first aspect, the apparatus of the second aspect or the conductive film of the third aspect and can hence be features of the conductive adhesive used as a part of the method, included as a part of the apparatus or used in forming a conductive film.

Preferably, the conductive beads have a rounded shape, for example they may be generally ellipsoidal or spherical. The conductive beads may have a ratio of the maximum dimension to the minimum dimension of 0.5 or greater, preferably 0.8 or greater and more preferably 0.95 or greater. For ellipsoidal shapes this corresponds to a ratio of the longest to the shortest axis. In a preferred embodiment generally spherical beads are used.

It is advantageous for the conductive beads to have a smooth shape, without rough edges. This results in better flow characteristics for the conductive adhesive. Spherical (or elliptical) beads are one preferred way to achieve this.

The conductive beads are metal coated polymer beads. The metal coating may comprise a single metal layer or multiple metal layers, for example a nickel seed layer with a further layer of silver or gold. The metal(s) of the metal coating may comprise one or more of copper, aluminium, nickel, silver, gold, palladium and/or platinum. A base metal may be deposited first, with a second layer of a more conductive metal then being deposited on the seed layer. Example combinations of metals for the base layer/second layer include copper/silver, nickel/silver, nickel/gold, nickel /palladium

The preferred polymer beads are spherical or close to spherical balls of polymer. Polymer beads of the sizes used herein are often referred to as micro-beads or micro-spheres.

Whilst significant advantages are achieved with conductive beads of a maximum dimension of 100 $\mu$m or less, a smaller maximum dimension is preferred. Thus, the conductive beads may have a maximum dimension of 80 $\mu$m, optionally a maximum dimension of 50 $\mu$m and in some preferred embodiments the maximum dimension is 30 $\mu$m, or less. When spherical polymer cores are used then the maximum dimension is the mean average diameter. The use of beads with larger diameters creates various disadvantages. The disadvantages include reduced conductivity, the need for a thicker bond line and reduced strength of the bonded adhesive. The reduced conductivity is as a consequence of the increased proportion of polymer in the adhesive compared to the amount of metal. The bond line thickness is the thickness of adhesive required between the two parts that are joined together. For a conductive adhesive the required thickness needs to take the need for conductivity into account as well as the bond strength. When larger beads are used the bond line thickness is increased, which is a disadvantage. Also, the use of larger beads leads to reduced shear strength for the bonded adhesive.

Thus, in one non-limiting example the mean average diameter of the conductive beads is less than 30 $\mu$m. The diameter of the polymer cores of the beads would be slightly smaller than this due to the thickness of the conductive metal coating.

Preferably the mean average diameter of the polymer cores of the beads is 25 $\mu$m or lower, more preferably 20 $\mu$m or lower. Reducing the mean average diameter provides increased conductivity and strength for the adhesive, and permits a thinner bond line.

There may be a minimum for the mean average diameter of the beads. The preferred minimum can vary between ACAs and ICAs and it can also vary for different uses of the adhesives. In some examples the minimum mean average diameter may be 2 $\mu$m, for example for an ACA at low volume fractions. The minimum may be higher, for example 3 $\mu$m or 4 $\mu$m.

In other preferred embodiments, for example for an ICA at higher volume fractions, the mean average diameter of the polymer cores of the beads is 5 $\mu$m or more. Preferably the mean average diameter of the polymer cores of the beads is more than 5 $\mu$m and more preferably it is 6 $\mu$m or above, optionally the mean average diameter is 10 $\mu$m or above. As the cores are made smaller the relative amount of metal for a given coating thickness increases since the surface area of the beads increases comparative to the volume of the beads. An adhesive product using smaller sized beads will include a higher proportion of metal than the equivalent product using larger sized beads and the same metal thickness. Whilst smaller sized beads will have advantages in relation to conductivity when the size of the beads is too small these advantages are not sufficient to outweigh the disadvantage of increased metal use and the consequent increased manufacturing cost. Hence a minimum average diameter is a preferred feature.

In a particularly preferred embodiment the polymer cores of the beads have a mean average diameter of between 6 $\mu$m and less than 30 $\mu$m, optionally excluding 6 $\mu$m, more preferably between 10 $\mu$m and 25 $\mu$m, optionally excluding the end points of this range and yet more preferably between 10 $\mu$m and 20 $\mu$m, optionally excluding the end points of this range. These ranges of average sizes are considered to provide the best compromise between the amount of metal required to create the necessary interlinked deposits whilst also keeping the beads small enough to provide the capability for a thinner bond line, higher conductivity and good mechanical properties for the cured adhesive. It will be understood that when selecting the mean average diameter for the polymer beads there are compromises between conductivity, mechanical properties and the amount of metal used. It has been found that good combinations of conductive and mechanical properties can be achieved with the use of beads having the preferred average diameters set out above.

The references to mean average diameter herein are references to a mean diameter of the polymer cores of the beads prior to coating with metal as measured by an instrument such as a Coulter Counter, by microscopy or by an equivalent technique.

In preferred embodiments the polymer cores of the conductive beads all have a coefficient of variation (CV) in diameter of less than 10%, preferably less than 5%, preferably less than 3%, and most preferably less than 2%. The CV value is defined by: CV = Standard deviation in diameter/Mean average diameter. It is also preferred to avoid "off size" particles with a diameter far from the average. Hence, preferably the incidence of conductive beads and/or polymer cores of the beads with a diameter greater than 1.5 times the mean diameter should be less than 1 in 1000 and more preferably less than 1 in 10 000. It is known that a broad size distribution of spherical particles increases the percolation threshold. (See, for example, R. Yazici et. al, "Particulate based conductive composites exploiting percolation-range microstructure", http://www.hfmi.stevens.edu/publications/147.PDF). Again, a broad size distribution will increase the consumption of metal to provide the same conductivity.

A smaller CV of the beads, in particular an absence of "off size" particles has been found to be particularly advantageous for an isotropic conductive adhesive since the beads in the isotropic adhesive can pack together with contact in several directions through the adhesive. This advantageous close packing is promoted when the diameters of the beads are within the preferred ranges set out above. A small CV and absence of off size beads is also advantageous for the flow characteristics of the adhesive as it is passed through the nozzle.

It can however also be useful in some applications to have a bimodal size distribution, wherein smaller particles fill in the gaps between larger particles. Thus, the adhesive may optionally comprise a bimodal distribution of particles with, for example, two sets of particles of differing average mean diameters.

The size of the largest conductive bead compared to the average is also of significance since one single large particle can result in blockage even when the overall CV is low. Therefore, the maximum dimension of the largest conductive bead in the conductive adhesive is less than three times the average. The maximum dimension of the largest conductive bead in the conductive adhesive is also less than half the nozzle width. Setting an appropriate maximum limit on permissible oversized beads avoids any risk of blockages and also ensures reliable and accurate deposition of droplets even when oversize beads are present.

The conductive adhesive may be an isotropic conductive adhesive or it may be an anisotropic conductive adhesive. The proposed method and apparatus provide advantages in each case compared to known techniques for application of conductive adhesives.

In one preferred example the adhesive is an isotropic conductive adhesive and preferably comprises a mixture of metal coated polymer beads and adhesive matrix with the polymer beads forming 20-60% of the mixture, by volume. Preferably the conductive beads form 25-55% and more preferably 45-50% of the volume of the mixture by volume. The percolation threshold for spheres is typically 30 - 40% by volume and hence it is preferred to exceed this threshold value. The percolation threshold in this context is a mathematical value for the threshold above which, in a random system, a fully interconnected network will be formed, in this case a network of beads forming a truly isotropically conductive network. If the amount of conductive beads is too low then the conductivity of the adhesive will be reduced. Conversely, if too many conductive beads are included then the mechanical properties of the cured adhesive can be adversely affected. For thin films of adhesive conductivity will be obtained at lower volume fractions.

At a volume fraction of about 17% one can say that conductivity in the X and Y directions essentially falls to zero and the adhesive becomes anisotropic. Discussion of the effect of volume fraction on conductivity can be found in US 2009/0288697. The volume fraction for conductive particles in anisotropic conductive adhesives is hence less than 17%. For anisotropic adhesives the volume fraction may be as low as 1%. These lower volume fractions can be used in 'single layer' adhesives, where the conductive connection is formed by isolated conductive beads spaced out in a single layer.

The adhesive matrix may be a thermoplastic composition for example one based on a primary component of a styrenic based or acrylate based linear polymer. Examples of suitable thermoplastic adhesive systems can be found in US 4740657. Preferably, the adhesive matrix may be based on a thermosetting resin such as, but not limited by, an epoxy resin, a crosslinkable polyurethane, a silicone, a polymerisable (meth)acrylic ester or cyano-acrylate or a thermoplastic material as exemplified by ethylene vinyl acetate or linear polyurethane. The adhesive matrix may be a heat curing adhesive or an adhesive cured by UV or visible light. The adhesive matrix is hence preferably a free radical polymerisable composition initiated either thermally or photolytically. A heat curing adhesive matrix is preferred. It is preferred that an adhesive is used that can be processed at temperatures less than 180°C, typically around 150°C. Adhesives that can be processed at lower temperatures, even room temperature curing adhesive, may be used.

The adhesive matrix may be made processable by heating or by the addition of a reactive or non-reactive solvent.

In a preferred embodiment the conductive beads comprise or consist of silver coated polymer beads. In a preferred embodiment, the silver coating comprises interlinked silver deposits grown from dispersed nucleation sites scattered across the surface of the beads. The use of silver coated polymer beads offers improvements over silver particles and metal coated glass beads. Less metal and fewer processes may be required to provide the required conductivity and compared to glass beads the polymer beads can be more closely matched in terms of mechanical properties to the properties of the surrounding adhesive matrix, including thermal expansion coefficient and elastic deformation. This minimises degradation in the adhesive that would otherwise occur under cycling thermal or mechanical loads.

The preferred metal coated polymer beads have diameters as discussed above. The thickness of the metal layer can also be important. Larger thicknesses will use a greater amount of metal and will also have a more significant effect on the mechanical properties of the sphere. However the larger thickness will improve conductivity. Conversely, when the metal layer is thinner then the silver usage and conductivity is reduced, but the mechanical properties of the coated polymer bead are influenced more by the polymer core. It is advantageous for the mechanical properties to be influenced by the polymer core rather than by the metal coating since the mechanical properties of the polymer core can more closely match the mechanical properties of the adhesive matrix. In order for the adhesive to operate as intended, the amount of metal and the extent of the metal coating should be sufficient to produce a low resistance metal layer around the polymer core. In addition, the volume fraction of the beads must be sufficient to form an interconnected conductive network in the adhesive matrix.

It will be understood that with the use of interlinked deposits grown from dispersed nucleation sites then the metal may grow outwardly from the surface of the polymer as well as growing along the surface starting from the nucleation site. This means that the thickness of the metal coating is not constant. When an average coating thickness is referenced herein it refers to a mean average thickness of the metal as determined, for example, by a density measurement using a pycnometer or similar device. A suitable instrument is the Multipycnometer manufactured by Quantathrome Instruments of Boynton Beach, Florida, USA.

To determine the amount of metal for present and to hence allow calculation of an average coating thickness using a density measurement technique first the volume of a measured weighted sample of beads comprising the pure polymer core is measured and the density of the polymer core is calculated. The volume and density measurement is then repeated for a measured weight sample of beads with the addition of the metal coating on the polymer core, with beads taken from the same polymer core batch as the pure polymer core sample. The volume of metal relative to the volume of the polymer core material can then calculated based on the differences in volume and density. An average metal thickness indicating a mean average thickness for the metal coating across the entire surface area of each bead can be determined from this using the mean average diameter of the beads. For particles with a broad size distribution it is important that the value for the average diameter used in the calculation is defined as the square root of an average of the square of the diameter, as in the formula below:

$$\text{Area weighted average diameter} = \sqrt[2]{\frac{\left(\Sigma_1^n d^2\right)}{n}}$$

where d represents the measured diameter of individual particles and n represents the number of particles measured. This gives an average based on the surface area of the particles - not an average diameter. If the particles are identical in size then the average diameter and area weighted average become the same.

The amount of metal in the metal coating derived from this measurement technique can be expressed as an absolute thickness or alternatively it can be expressed as a volume of metal relative to the volume of the coated particles. Defining the thickness based on a relative volume of metal, for example as a volume percentage (vol%), gives a measure of the metal thickness that is independent of the mean average diameter. The vol% of metal in the coated particles is of course directly related to the thickness when expressed as a percentage of the core diameter.

The average thickness of the metal measured in this way may be 350 nm or less and/or less than 5% of the core diameter, preferably less than 3.5% of the core diameter, most preferably less than 3% of the core diameter and optionally less than 1.7% of the core diameter. If expressed as a vol% of metal in the coated particles then a thickness of less than 3% of the core diameter equates to a maximum of about 16.9 vol% of metal in the coated particles. The maximum permitted thickness may be the larger of 350 nm and the percentage values set out above. For smaller diameters an average thickness of more than the percentage values can be tolerated and it can be advantageous in terms of conductivity to permit a higher maximum. However, with thicker metal coatings the mechanical properties of the coated polymer beads can be dominated by the metal coating and as noted above it is preferred for the properties to be more heavily influenced by the polymer core. Also, as the coating becomes thicker the disadvantage of increased costs for the additional metal can outweigh any benefits from increased conductivity.

It is preferred for the average thickness of the metal coating to be more than 0.5% of the core diameter, preferably more than 0.7% of the core diameter and optionally more than 0.85% of the core diameter. These levels of metal are expected to provide good conductivity whilst also minimising material costs and limiting the effect of the coating on the mechanical properties of the beads. Alternatively, the average thickness of the metal may be more than 50 nm, more preferably more than 100 nm. The minimum average thickness for the coating may be set as the smaller out of one of these values and one of the percentage values above. For larger diameters an average thickness of less than the preferred percentage values above can be tolerated and thicknesses over these values can provide sufficient conductivity even at the larger diameters. A value of 50 nm with core diameters of 20 μm to 25 μm gives a thickness of 0.25% to 0.2% of the diameter. Some preferred embodiments use a thickness of more than 120 nm for enhanced conductivity.

In some preferred embodiments the average diameter of the polymer cores of the beads is between 2 μm and less than 30 μm, preferably between 6 μm and less than 30 μm, optionally excluding 6 μm, more preferably between 10 μm and 20 μm, optionally excluding the end points of this range; and the average thickness of the coating, measured as above, is above 50 nm and below 350 nm, preferably above 100 nm, preferably below 200 nm; and/or with an average thickness of between 0.7% and 3% of the core diameter. These combinations of thickness and diameter values have been found to give particularly good results.

Full coverage of the particle with metal is not a prerequisite for the functionality of the product. It is however preferred that the coverage be more than 80% of the particle surface area and more preferred complete coverage. This leads to the best conductive properties for the adhesive.

The metal coating may be deposited on the polymer core by a number of methods. The most applicable are the methods collectively called electroless-plating. Electro-plating is also theoretically possible but extremely difficult on such small particles. Electroless-plating of metal on a polymer requires activation of the surface. In an example coating process, catalytic quantities of metals atoms illustrated by but not restricted to palladium, platinum or silver are distributed evenly over the surface of the polymer core. This may be achieved by methods including vapour deposition, impregnation with a salt of the metal followed by reduction to the metallic state or by sensitisation by acidic tin chloride followed by a salt such as palladium chloride. The methods are numerous and well known to one skilled in the art. Metal may then be deposited by the reduction of metal ions from an appropriate soluble salt. In one preferred example the metal coating is a silver coating and the salt may be silver nitrate or silver sulphate. This reaction may be performed with a number of reducing agents illustrated by but not restricted to hydrazine, dimethyl ammonium borane, sugars such as glucose and fructose or ascorbic acid. In this example process metal deposition is initially catalysed by the activating metal and then thereafter by the metal layer forming. The metal deposition becomes autocatalytic. Not to be restricted by any one model it is believed that clusters of metal atoms are required to catalyse the metal reduction. Single atoms are not believed to be adequate.

The polymer beads of the preferred embodiments may comprise any suitable polymer material. Preferred materials are styrenics, acrylates and methacrylate, vinyl polymers and condensation polymers including polyesters, epoxy resins, phenol-aldehyde polymers and polyurethanes.

Particles may be produced by any method including emulsion polymerisation, suspension polymerisation, or dispersion polymerisation. Narrow size distributions may be obtained by using seeded polymerisations as described in US-A-4336173, US-A-4459378, US-A-6291553, DE 19634393, and US-A-6346592. Membrane, capillary techniques or any other method known to one skilled in the art may also be used.

The polymer beads may, for example, be prepared from styrene, e.g. styrene crosslinked with divinylbenzene. Other styrene monomers of use in the invention include methylstyrene and vinyl toluene. Mixtures of styrene monomers may be used. Another option is polymer beads prepared from acrylic acid esters, methacrylic acid esters, acrylic acids, methacrylic acids, acrylonitrile, methacrylonitrile, vinyl chloride, vinyl acetate and vinyl propionate. Mixtures of any of these monomers can also be used optionally together with the styrene monomers above. All monomers can be crosslinked with divinylbenzene or a diacrylic monomer such as ethane-diol-diacrylate. Some seeds may require treatment with base to hydrolyse ester groups to allow cross-linking. The use of a cross-linking agent and hence the formation of a cross-linked seed is preferred.

Still another method for preparing polymer beads involves copolymerization of mixed anhydrides such as acrylic acid-acetic acid anhydride, or maleic and/or fumaric anhydride with styrene, and a small amount of divinylbenzene, and finally hydrolyzing the product. Some seed monomers may comprise epoxy groups such as glycidol methacrylate. The skilled man is able to select the monomer combination and cross-linker he wants using his general knowledge.

Preferred polymer beads comprise a styrene, an acrylate or a methacrylate. Highly preferred monomers therefore include styrene, acrylic acid, butyl acrylate, 2-ethylhexyl acrylate, methyl acrylate, ethyl acrylate, acrylonitrile, divinylbenzene, methyl methacrylate, methacrylate, ethyleneglycol diacrylate hexanediol diacrylate and trimethylolpropane triacrylate (TMPTA).

Certain preferred embodiments will now be described by way of example only and with reference to the accompanying drawings in which:

Figure 1 is a schematic drawing showing a conventional isotropic conductive adhesive using silver flakes;
Figures 2a and 2b illustrates the distinction between isotropic conductive adhesives and anisotropic conductive adhesives;
Figure 3 is a similar schematic drawing to Figure 1 showing an isotropic conductive adhesive using metal coated polymer beads;

Figure 4 shows an example of a conductive adhesive applied by depositing droplets to build up adhesive in strips;

Figure 5 shows a similar example to Figure 4 with droplets deposited to form dots; and

Figure 6 shows an apparatus for depositing droplets of conductive adhesive through a circular nozzle.

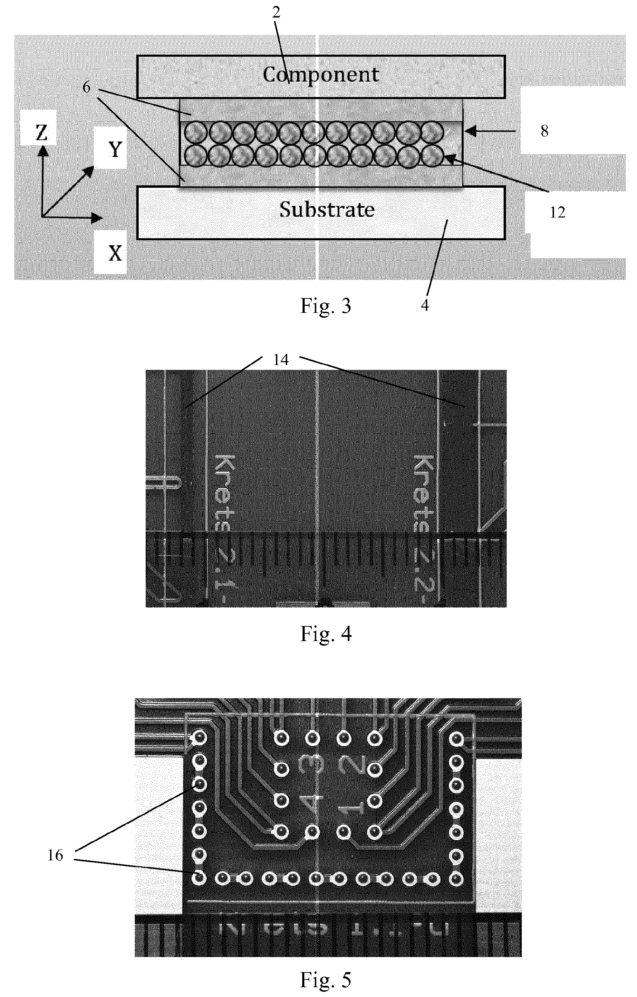

The invention concerns the application of a conductive adhesive (CA), which by way of example can be an isotropic conductive adhesive of the type shown in Figure 3. It will of course be appreciated that the method and apparatus described below with reference to Figures 4 to 6 could readily be adapted for use with other adhesives comprising alternative types of conductive beads 12 and is not limited to isotropic conductive adhesives but also could utilise anisotropic conductive adhesives.

As with the CA of Figure 1 the CA of Figure 3 connects a component 2 to a substrate 4. Both of the component 2 and substrate 4 have an electrical contact 6. The CA comprises an adhesive matrix 8 and metal coated polymer beads 12. In this case, and by way of example the metal coating is a silver coating. It will however be appreciated that the general principles described herein have a wider utility and that other metals could be used, as discussed above. In practice the beads 12 would generally not be aligned perfectly as shown in the Figure. Instead the beads 12 can be located almost randomly during flow of the CA onto the contact(s) 6. The volume fraction of beads 12 in the mixture of beads 12 and adhesive matrix is set so as to ensure that an isotropically conductive network of beads 12 is formed. To obtain isotropic properties will typically require in excess of 40% of beads, by volume. Examples are given below. Lower volume fractions, for example less than 17% of beads, by volume, can be used to obtain an anisotropic conductive adhesive.

The metal coating, a silver coating in this example, provides the required conductivity for the CA. The adhesive matrix, when cured, provides the strength for the joint between the two parts. The polymer cores of the beads 12 provides a high and also controllable degree of flexibility of the adhesive by allowing the selection of suitable polymer compositions with adjusted mechanical properties that can be matched with the mechanical properties of the adhesive matrix. Since the metal layer on the polymer bead is relatively thin then the coated bead has mechanical properties highly influenced by the polymer core. This allows, for instance, the coefficient of thermal expansion (CTE) and the elastic modulus of the conductive fillers to be much better matched to those of the epoxy resin in contrast to what is possible when loading the adhesive with the solid metal particles. Thereby the local stress concentrated at the interfaces between the conductive fillers and the resin can be reduced. Possible combinations of materials for the adhesive matrix and polymer beads are given in the examples below.

The polymer beads in the preferred embodiments are produced by emulsion, suspension or dispersion polymerisation, or more preferably, in order to produce smaller polydispersity, by a seeded polymerisation.

The metal coating, silver in this example, is added by electroless-plating. An example process is described in Example 1 below. Other suitable plating methods may be used in alternative embodiments. An example of a process for producing embodiments of conductive adhesives based on silver coated polymer particles is set out in Example 2. Examples 3.1 to 3.9 illustrate possible combinations of particle diameter and silver thickness for beads produced by routine adaptation of the method of Example 1. The particle diameter is the mean average diameter of the polymer core and the silver thickness is the average thickness as measured using the technique described above. Measured conductivity values are also included for conductive adhesives using a selection of the coated beads of Examples 3.1 to 3.9, where the conductive adhesives are produced using the process of Example 2.

Example 1: In a first example 50g polymer particles comprised of a copolymer of methylmethacrylate and ethyleneglycol dimethacrylate with average diameter of 15 microns were soaked in 150ml a solution of $SnCl_2$ (20g/l $SnCl_2$ 30g/l Concentrated HCl) at room temperature for 30 minutes. The particles were washed and then soaked in 150ml Palladium Chloride solution (0.2g/l $PdCl_2$ for 30 minutes). The particles were then coated with silver from a solution of silver nitrate and triethylene tetramine ($AgNO_3$ 44.9g TETA 83g) reduced by ascorbic acid (90g) at 40°C. The product was washed and dried. The product was a free flowing grey powder with a theoretical average silver thickness of 150nm.

Example 2: One production method used to make conductive adhesives based on metal coated polymer particles is as below. In this example the adhesive is applied to a test board. The application process can be adapted using routine techniques to apply the adhesive to fix any desired component(s).

    i. Mix the selected epoxy system by mixing part A and part B in accordance with the technical data sheet. Araldite PY302-2 mixed with JEFFAMINE D-230 at weight ratio 100:35 (both available from Huntsman Advanced Materials (Switzerland) GmbH) is used for the adhesives in Example 3.

    ii. Add a predetermined weight of particles to the mixed epoxy system. The weight of particles is selected to achieve the required volume % of filler in the final isotropic or anisotropic adhesive system.

    iii. Speed mix the adhesive in 20 ml containers at 2000 rpm for 2 min, and then transfer into a reservoir.

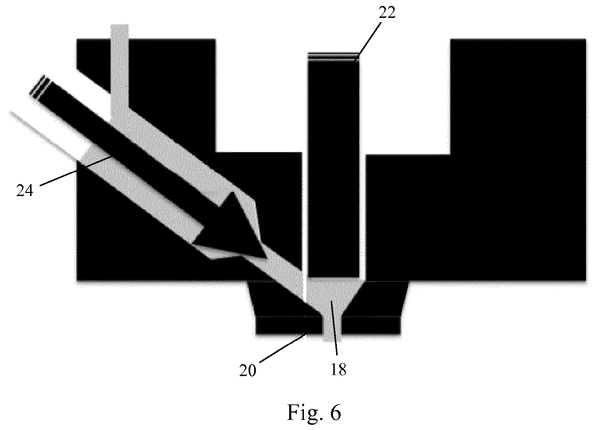

    iv. Apply the adhesive to a PCB board designed to test four point resistance, using a machine that applies the conductive adhesive through a nozzle, such as the machine of Figure 6, which is discussed below.

    v. Cure the samples for 15 min at 150 degrees Celsius.

vi. Cool the sample to Room Temperature.

Examples 3.1 to 3.9: With different diameters for the starting particles and using a scaled version of method 1 compensating for surface area and desired metal thickness then various combinations of diameter and silver thickness can be produced. The combinations of values in the table below are examples of appropriate combinations for conductive adhesive products.

|             | Particle diameter | Silver thickness |
|-------------|-------------------|------------------|
| Example 3.1 | 6 $\mu$m          | 100 nm           |
| Example 3.2 | 6 $\mu$m          | 150 nm           |
| Example 3.3 | 10 $\mu$m         | 100 nm           |
| Example 3.4 | 10 $\mu$m         | 150 nm           |
| Example 3.5 | 15 $\mu$m         | 100 nm           |
| Example 3.6 | 15 $\mu$m         | 150 nm           |
| Example 3.7 | 20 $\mu$m         | 150 nm           |
| Example 3.8 | 20 $\mu$m         | 200 nm           |

Certain coated particles from the examples above were incorporated into an adhesive product using the process of Example 2 with volumes of particles as set out in the table below.

| Particle from; | Vol% in Araldite PY302-2 : JEFFAMINE D-230 |
|----------------|--------------------------------------------|
| Example 3.1    | 40 Vol%                                    |
| Example 3.2    | 50 Vol%                                    |
| Example 3.4    | 35 Vol%                                    |
| Example 3.4    | 45 Vol%                                    |
| Example 3.4    | 50 Vol%                                    |
| Example 3.5    | 48 Vol%                                    |

In an alternative to the method of Example 2 the polymer particles could be introduced prior to or simultaneously with the step of mixing of the epoxy system. For example, the particles could be mixed in the separate epoxy components (or one of the two components) followed by mixing the epoxy compounds together.

With the above exemplary volume fractions the resulting conductive adhesives would be isotropic conductive adhesives. The same combinations of adhesive resins and metal coated polymers could be used to produce anisotropic conductive adhesives by reducing the volume fraction of the conductive beads, for example to 17% by volume or below.

Figure 4 is an example of conductive adhesives applied by a nozzle and shows samples of conductive adhesives applied via droplets deposited in strips 14. Figure 5 shows a similar example with the conductive adhesive applied via droplets to form in dots 16. The strips 14 and dots 16 are built up by application of multiple small droplets. As can be seen from the rule in the images, which has a mm scale, the dots 16 and strips 14 are at a very small scale, with the widths of the strips 14 being 2.55 mm and 0.95 mm and the dots 16 being approximately circular with a diameter of approximately 460 $\mu$m. In this case the droplets used consisted of about 5 nl of CA and were applied via a nozzle with an opening having a diameter of 150 $\mu$m. The CA used silver coated polymer beads of the type discussed above and in these samples the diameters of the polymer cores were 6 $\mu$m, with a coating of thickness of 100 nm and the beads were mixed with an Araldite PY302-2 mixed with JEFFAMINE D-230 at weight ratio 100:35 (both available from HUNTSMAN) epoxy resin with 20 Vol% of filler. Several droplets of CA with different composition have also been applied via the same nozzle, some of which are mentioned in the table below.

|             | Particle diameter | Silver thickness | Volume filler in CA | Droplet volume | # Droplets on pad | Approximately Dot diameter |
|-------------|-------------------|------------------|---------------------|----------------|-------------------|----------------------------|
| Example 4.1 | 6 $\mu$m          | 100 nm           | 20%                 | < 5nl          | single            | 330 $\mu$m                 |

(continued)

|  | Particle diameter | Silver thickness | Volume filler in CA | Droplet volume | # Droplets on pad | Approximately Dot diameter |
|---|---|---|---|---|---|---|
| Example 4.2 | 6 $\mu$m | 100 nm | 20% | 5nl | multiple | 800 $\mu$m |
| Example 4.3 | 6 $\mu$m | 100 nm | 40% | 5nl | multiple | >1000 $\mu$m |
| Example 4.4 | 6 $\mu$m | 100 nm | 40% | 5nl | multiple | 800 $\mu$m |
| Example 4.5 | 6 $\mu$m | 100 nm | 48% | 5nl | multiple | 800 $\mu$m |
| Example 4.6 | 10 $\mu$m | 100 nm | 40% | 5nl | single | 500 $\mu$m |
| Example 4.7 | 10 $\mu$m | 100 nm | 40% | 5nl | multiple | 800 $\mu$m |

A preferred embodiment of an apparatus for applying the CA is shown in Figure 6, in which a volume of conductive adhesive 18 is held within a chamber adjacent to a nozzle 20 and is deposited from the nozzle 20 in droplets via the action of a piston 22. The adhesive 18 is conveyed to the nozzle 20 by a suitable pumping device, such as a screw 24 for example. The principles of this apparatus are similar to known devices for deposition of droplets of solder pastes, as described for example in US 7767266. However, in contrast to the use of solder paste there is no requirement for heating since the conductive adhesive 18 can be applied at room temperature. The piston 22 propels an accurately controlled amount of adhesive 18 from the nozzle 20 onto a substrate below. The droplet size and the size of the applied area of adhesive can be as discussed above.

In a further example embodiment the nozzle can be used to deposit conductive adhesive onto a release paper. In this way, as discussed above, conductive films can be created. This embodiment can use an apparatus as shown in Figure 6 along with an adhesive composition selected based on the desired properties of the resultant conductive film. Droplets can be deposited on the release paper in strips similar to those in Figure 4, or alternatively in patterns to thereby form conductive films with customised shapes.

## Claims

1. A method of applying a conductive adhesive comprising: using a conductive adhesive made up of conductive beads in an adhesive matrix, the conductive beads being metal coated polymer beads comprising a polymer core with a conductive metal coating and having a maximum dimension of 100 $\mu$m or less; and depositing one or more droplet(s) of the adhesive on a substrate via a nozzle;

   wherein the maximum dimension of the largest conductive bead in the conductive adhesive is half the nozzle width or less;
   wherein the maximum dimension of the largest conductive bead is less than three times the average maximum dimension of the conductive beads; and
   wherein the nozzle has an opening with a width of at least three times the average maximum dimension of the conductive beads.

2. An apparatus for applying conductive adhesive comprising: a nozzle; and a reservoir of a conductive adhesive made up of conductive beads in an adhesive matrix; wherein the conductive beads are metal coated polymer beads that comprise a polymer core with a conductive metal coating and have a diameter of 100 $\mu$m or less and wherein the apparatus is arranged to dispense adhesive from the reservoir by depositing one or more droplet(s) of the adhesive on a substrate via the nozzle;

   wherein the maximum dimension of the largest conductive bead in the conductive adhesive is half the nozzle width or less;
   wherein the maximum dimension of the largest conductive bead is less than three times the average maximum dimension of the conductive beads; and
   wherein the nozzle has an opening with a width of at least three times the average maximum dimension of the conductive beads.

3. A method or an apparatus as claimed in claim 1 or 2, wherein the width of the nozzle is 300 $\mu$m or less.

4. A method or an apparatus as claimed in claim 3, wherein the width of the nozzle is 150 $\mu$m or less.

5. A method or an apparatus as claimed in any preceding claim, wherein the conductive beads have a maximum dimension of 30 $\mu$m or less, and the nozzle has an opening with a width up to a maximum of 300 $\mu$m.

6. A method or an apparatus as claimed in any preceding claim, wherein the polymer cores are spherical or close to spherical balls of polymer.

7. A method or an apparatus as claimed in any preceding claim, wherein the conductive beads have a maximum dimension of 50 $\mu$m.

8. A method or an apparatus as claimed in claim 7, wherein the conductive beads have a maximum dimension of 30 $\mu$m.

9. A method or an apparatus as claimed in any preceding claim, wherein the metal coating of the conductive beads comprises one or more of copper, aluminium, tin, nickel, silver, gold, palladium and/or platinum.

10. A method or an apparatus as claimed in any preceding claim, wherein the conductive beads comprise or consist of silver coated polymer beads.

11. A method or an apparatus as claimed in claim 10, wherein the silver coating comprises interlinked silver deposits grown from dispersed nucleation sites scattered across the surface of the beads.

12. A method or an apparatus as claimed in any preceding claim, wherein the substrate is a release layer and the method or apparatus is for producing an anisotropic or isotropic conductive film by deposition of the adhesive onto the release layer.

13. A method or an apparatus as claimed in any preceding claim, wherein the polymer cores of the conductive beads have a coefficient of variation (CV) in diameter of less than 10%.

14. A method or an apparatus as claimed in claim 13, wherein the polymer cores of the conductive beads have a coefficient of variation (CV) in diameter of less than 3%.

15. A method or an apparatus as claimed in any of claims 1 to 12, wherein the conductive beads have a bimodal size distribution, wherein smaller conductive beads fill in gaps between larger conductive beads.

**Patentansprüche**

1. Verfahren zum Auftragen eines leitenden Haftmittels, umfassend: Verwenden eines leitenden Haftmittels, das aus leitenden Perlen in einer Haftmittelmatrix hergestellt ist, wobei die leitenden Perlen metallbeschichtete Polymerperlen sind, die einen Polymerkern mit einer leitenden Metallbeschichtung umfassen und eine Höchstabmessung von 100 $\mu$m oder weniger aufweisen; und Ablegen von einem oder mehreren Tröpfchen des Haftmittels auf einem Substrat über eine Düse;

   wobei die Höchstabmessung der größten leitenden Perle im leitenden Haftmittel die Hälfte der Düsenbreite oder weniger ist;
   wobei die Höchstabmessung der größten leitenden Perle weniger als dreimal die durchschnittliche Höchstabmessung der leitenden Perlen ist; und
   wobei die Düse eine Öffnung mit einer Breite von mindestens dreimal der durchschnittlichen Höchstabmessung der leitenden Perlen aufweist.

2. Vorrichtung zum Auftragen von leitendem Haftmittel, umfassend: eine Düse; und einen Behälter mit einem leitenden Haftmittel, das aus leitenden Perlen in einer Haftmittelmatrix hergestellt ist; wobei die leitenden Perlen metallbeschichtete Polymerperlen sind, die einen Polymerkern mit einer leitenden Metallbeschichtung umfassen und einen Durchmesser von 100 $\mu$m oder weniger aufweisen, und wobei die Vorrichtung so angeordnet ist, dass sie Haftmittel aus dem Behälter durch Ablegen von einem oder mehreren Tröpfchen des Haftmittels auf einem Substrat über die Düse abgibt;

wobei die Höchstabmessung der größten leitenden Perle im leitenden Haftmittel die Hälfte der Düsenbreite oder weniger ist;

wobei die Höchstabmessung der größten leitenden Perle weniger als dreimal die durchschnittliche Höchstabmessung der leitenden Perlen ist; und

wobei die Düse eine Öffnung mit einer Breite von mindestens dreimal der durchschnittlichen Höchstabmessung der leitenden Perlen aufweist.

3. Verfahren oder Vorrichtung nach Anspruch 1 oder 2, wobei die Breite der Düse 300 $\mu$m oder weniger beträgt.

4. Verfahren oder Vorrichtung nach Anspruch 3, wobei die Breite der Düse 150 $\mu$m oder weniger beträgt.

5. Verfahren oder Vorrichtung nach einem vorstehenden Anspruch, wobei die leitenden Perlen eine Höchstabmessung von 30 $\mu$m oder weniger aufweisen und die Düse eine Öffnung mit einer Breite von bis zu maximal 300 $\mu$m aufweist.

6. Verfahren oder Vorrichtung nach einem vorstehenden Anspruch, wobei die Polymerkerne sphärische oder fast sphärische Polymerkugeln sind.

7. Verfahren oder Vorrichtung nach einem vorstehenden Anspruch, wobei die leitenden Perlen eine Höchstabmessung von 50 $\mu$m aufweisen.

8. Verfahren oder Vorrichtung nach Anspruch 7, wobei die leitenden Perlen eine Höchstabmessung von 30 $\mu$m aufweisen.

9. Verfahren oder Vorrichtung nach einem vorstehenden Anspruch, wobei die Metallbeschichtung der leitenden Perlen eines oder mehreres umfasst von Kupfer, Aluminium, Zinn, Nickel, Silber, Gold, Palladium und/oder Platin.

10. Verfahren oder Vorrichtung nach einem vorstehenden Anspruch, wobei die leitenden Perlen silberbeschichtete Polymerperlen umfassen oder daraus bestehen.

11. Verfahren oder Vorrichtung nach Anspruch 10, wobei die Silberbeschichtung vernetzte Silberablagerungen umfasst, die aus über die Oberfläche der Perlen gestreuten verteilten Kristallisationszentren gewachsen sind.

12. Verfahren oder Vorrichtung nach einem vorstehenden Anspruch, wobei das Substrat eine Trennfolie ist und das Verfahren oder die Vorrichtung zum Herstellen einer anisotropen oder isotropen leitenden Folie durch Ablage des Haftmittels auf der Trennfolie dient.

13. Verfahren oder Vorrichtung nach einem vorstehenden Anspruch, wobei die Polymerkerne der leitenden Perlen einen Variationskoeffizienten (CV) des Durchmessers von weniger als 10 % aufweisen.

14. Verfahren oder Vorrichtung nach Anspruch 13, wobei die Polymerkerne der leitenden Perlen einen Variationskoeffizienten (CV) im Durchmesser von weniger als 3 % aufweisen.

15. Verfahren oder Vorrichtung nach einem der Ansprüche 1 bis 12, wobei die leitenden Perlen eine bimodale Größenverteilung aufweisen, wobei kleinere leitende Perlen Spalte zwischen größeren leitenden Perlen ausfüllen.

**Revendications**

1. Procédé d'application d'un adhésif conducteur comprenant : l'utilisation d'un adhésif conducteur constitué de billes conductrices dans une matrice adhésive, les billes conductrices étant des billes de polymère revêtu de métal comprenant un noyau polymère avec un revêtement de métal conducteur et présentant une dimension maximale de 100 $\mu$m ou moins ; et le dépôt d'une ou de plusieurs gouttelettes de l'adhésif sur un substrat par l'intermédiaire d'une buse ;

la dimension maximale de la bille conductrice la plus grande dans l'adhésif conducteur étant une moitié de la largeur de la buse ou moins ;

la dimension maximale de la bille conductrice la plus grande étant moins de trois fois la dimension maximale moyenne des billes conductrices ; et

dans lequel la buse présente une ouverture avec une largeur d'au moins trois fois la dimension maximale moyenne des billes conductrices.

2. Appareil permettant l'application d'un adhésif conducteur comprenant : une buse ; et un réservoir d'un adhésif conducteur constitué de billes conductrices dans une matrice adhésive ; dans lequel les billes conductrices sont des billes de polymère revêtu de métal qui comprennent un noyau polymère avec un revêtement de métal conducteur et qui présentent un diamètre de 100 $\mu$m ou moins, et dans lequel l'appareil est agencé de manière à distribuer l'adhésif à partir du réservoir par dépôt d'une ou plusieurs gouttelettes de l'adhésif sur un substrat par l'intermédiaire de la buse ;

la dimension maximale de la bille conductrice la plus grande dans l'adhésif conducteur étant une moitié de la largeur de buse ou moins ;
la dimension maximale de la bille conductrice la plus grande étant moins de trois fois la dimension maximale moyenne des billes conductrices ; et
dans lequel la buse présente une ouverture avec une largeur d'au moins trois fois la dimension maximale moyenne des billes conductrices.

3. Procédé ou appareil tel que revendiqué dans la revendication 1 ou la revendication 2, dans lequel la largeur de la buse est 300 $\mu$m ou moins.

4. Procédé ou appareil tel que revendiqué dans la revendication 3, dans lequel la largeur de la buse est 150 $\mu$m ou moins.

5. Procédé ou appareil tel que revendiqué dans une quelconque revendication précédente, dans lequel les billes conductrices présentent une dimension maximale de 30 $\mu$m ou moins, et la buse présente une ouverture avec une largeur jusqu'à un maximum de 300 $\mu$m.

6. Procédé ou appareil tel que revendiqué dans une quelconque revendication précédente, dans lequel les noyaux polymères sont sphériques ou proches de billes sphériques de polymère.

7. Procédé ou appareil tel que revendiqué dans une quelconque revendication précédente, dans lequel les billes conductrices présentent une dimension maximale de 50 $\mu$m.

8. Procédé ou appareil tel que revendiqué dans la revendication 7, dans lequel les billes conductrices présentent une dimension maximale de 30 $\mu$m.

9. Procédé ou appareil tel que revendiqué dans une quelconque revendication précédente, dans lequel le revêtement de métal des billes conductrices comprend un ou plusieurs de cuivre, d'aluminium, d'étain, de nickel, d'argent, d'or, de palladium et/ou de platine.

10. Procédé ou appareil tel que revendiqué dans une quelconque revendication précédente, dans lequel les billes conductrices comprennent ou consistent en des billes de polymère revêtu d'argent.

11. Procédé ou appareil tel que revendiqué dans la revendication 10, dans lequel le revêtement d'argent comprend des dépôts d'argent interconnectés ayant grandi à partir de sites de nucléation dispersés diffusés sur la surface des billes.

12. Procédé ou appareil tel que revendiqué dans une quelconque revendication précédente, dans lequel le substrat est une couche de libération et le procédé ou l'appareil est pour la production d'un film conducteur anisotrope ou isotrope par dépôt de l'adhésif sur la couche de libération.

13. Procédé ou appareil tel que revendiqué dans une quelconque revendication précédente, dans lequel les noyaux polymères des billes conductrices présentent un coefficient de variation (CV) en diamètre de moins de 10 %.

14. Procédé ou appareil tel que revendiqué dans la revendication 13, dans lequel les noyaux polymères des billes conductrices présentent un coefficient de variation (CV) en diamètre de moins de 3 %.

15. Procédé ou appareil tel que revendiqué dans l'une quelconque des revendications 1 à 12, dans lequel les billes conductrices présentent une distribution de taille bimodale, dans lequel des billes conductrices plus petites remplissent des interstices entre des billes conductrices plus grandes.

Fig. 1

Fig. 2a

Fig. 2b

Fig. 3

Fig. 4

Fig. 5

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6942824 B
- US 6315856 B1
- US 7767266 B
- US 20090288697 A
- US 4740657 A
- US 4336173 A
- US 4459378 A
- US 6291553 A
- DE 19634393
- US 6346592 A